# EUROPEAN PATENT APPLICATION

(11) **EP 4 683 434 A1**
(43) Date of publication of application: **21.01.2026**
(21) Application number: 24894445.6
(22) Date of filing: 01.11.2024
(51) Int. Cl.: H05K 1/03, H05K 3/38

(54) **INSULATION FILM AND PRINTED CIRCUIT BOARD COMPRISING SAME**

(30) Priority: 21.11.2023 KR 20230161738; 31.10.2024 KR 20240152453
(71) Applicant: LG Chem, Ltd., Seoul 07336 (KR)
(72) Inventor: KIM, Bokyung, Daejeon 34122 (KR); PARK, Jun Wuk, Daejeon 34122 (KR); KIM, Tae Soon, Daejeon 34122 (KR); YOON, Youngsik, Daejeon 34122 (KR); HWANG, Seongmin, Daejeon 34122 (KR)
(74) Representative: Hoffmann Eitle
(86) International application number: PCT/KR2024/017001
(87) International publication number: WO 2025/110551

(57) **Abstract**

The present specification provides insulation film and a printed circuit board comprising same, the insulation film comprising: a first layer comprising epoxy-based resin, a cyanate ester-based resin, and an inorganic filler surface-treated with phenylamino silane; and a second layer comprising epoxy-based resin, phenol-based resin, and an inorganic filler surface-treated with epoxy silane.

## Description

### [Technical Field]

The present disclosure relates to an insulating film and a printed circuit board including the same.

The present application claims the benefit of Korean Patent Application No. 10-2023-0161738 filed on November 21, 2023 and Korean Patent Application No. 10-2024-0152453 filed on October 31, 2024, in the Korean Intellectual Property Office, the entire disclosure of which is incorporated herein by reference.

### [Background Art]

A printed circuit board (PCB) is a support of electronic parts and refers to a board that fixes electronic parts to the surface of a printed wiring board and connects the parts with one another through copper wiring to form an electronic circuit.

In general, a printed circuit board is based on forming multiple layers by insulating copper wires. In order to increase the reliability of a board, there has been suggested a method for improving the adhesion between an insulating layer and a copper foil layer by incorporating an ingredient having high binding force with Cu to the insulating layer, forming surface roughness on the insulating layer to increase the surface area of the interface, or the like.

As a method for fabricating a multilayer printed circuit board, there is known a method including stacking copper foil on an inner layer circuit board having a circuit formed thereon by using a prepreg sheet and carrying out interlayer connection by a through-hole. However, such a method is problematic in that it requires a large-scale facility, consumes a lot of costs and times and has a difficulty in forming a micropattern.

As a solution for the above-mentioned problems, a method for fabricating a multilayer printed circuit board to which a build-up method is incorporated has been suggested recently. The build-up method is a technology of stacking a conductor layer of a circuit board and an organic insulating layer (or insulating film) alternately, and includes the steps of vacuum lamination of an insulating film, precuring, drilling, roughening treatment, electroless plating, electroplating, post-curing and forming an outer layer circuit.

In the applicable technical field, there is a need for an insulating film having not only high adhesion to conductor wiring forming a conductive layer but also excellent chemical resistance, or the like, in order to improve the quality of a multilayer printed circuit board.

In addition, there is a need for an insulating film having high heat resistance and low dielectric properties, as a low dissipation factor is in increasingly in demand recently.

### [References]

### [Patent Documents]

Korean Patent Laid-Open No. 2012-0107277

### [Disclosure]

### [Technical Problem]

The present disclosure is directed to providing an insulating film and a printed circuit board including the same.

### [Technical Solution]

An exemplary embodiment of the present disclosure provides an insulating film including:
a first layer including an epoxy-based resin, a cyanate ester-based resin and an inorganic filler surface-treated with phenylaminosilane; and
a second layer including an epoxy-based resin, a phenol-based resin and an inorganic filler surface-treated with epoxysilane.

Another exemplary embodiment of the present disclosure provides a printed circuit board including the insulating film.

### [Advantageous Effects]

An insulating film according to an exemplary embodiment of the present disclosure has a low coefficient of linear thermal expansion, and thus can prevent cracking in a subsequent reliability test of the insulating film.

In addition, the insulating film according to an exemplary embodiment of the present disclosure shows a low surface roughness and high plating adhesion.

Further, the insulating film according to an exemplary embodiment of the present disclosure shows excellent dielectric properties.

### [Best Mode]

Hereinafter, the present disclosure will be explained in more detail.

Throughout the present specification, when a certain member is described to be located "on" another member, this includes not only the case where the member is in contact with said another member but also the case where another member exists between the two members.

Throughout the present specification, when a part is described to "include" a component, this does not exclude the presence of another component but rather implies that further components may be included, unless the context specifically states otherwise.

As a method for fabricating a multilayer printed circuit board, a method including stacking a conductor layer and an insulating film alternately has been developed and used for semiconductor packaging currently. Such a process for fabricating a multilayer printed circuit board includes vacuum laminating a build-up insulating film on an inner layer circuit first, and then the steps of precuring → drilling → roughening treatment → electroless plating → electroplating → post-curing → forming an outer layer circuit. Herein, the roughening treatment step functions to remove smears with an acidic solution while causing erosion of a predetermined amount of the insulating film to form surface roughness. This functions to increase the adhesion to a copper foil layer to be formed in the subsequent step.

A higher surface roughness after carrying out the roughening treatment is advantageous in terms of the adhesion of the copper foil layer with the insulating layer. However, when the surface roughness is excessively high, the time required for removing the electroless plating is increased unsuitably. Therefore, there is a need for developing an insulating film having a low surface roughness as well as high plating adhesion.

According to the related art, a composition including an epoxy resin and a phenolic curing agent with silica particles as inorganic fillers has been used for fabricating a build-up insulating film. However, as a need for low dielectric properties and low coefficient of thermal expansion (CTE) has been increased, a product using a cyanate ester-based curing agent with an epoxy resin has been developed.

However, when a cured product of the epoxy resin with the cyanate ester-based curing agent is used alone, there is a problem in that a desired level of surface roughness cannot be formed through a roughening treatment step.

Therefore, the present disclosure is directed to providing an insulating film showing not only low CTE properties but also a desired surface roughness and high plating adhesion, and a printed circuit board including the same.

An exemplar embodiment of the present disclosure provides an insulating film including: a first layer including an epoxy-based resin, a cyanate ester-based resin and an inorganic filler surface-treated with phenylaminosilane; and a second layer including an epoxy-based resin, a phenol-based resin and an inorganic filler surface-treated with epoxysilane.

In an exemplary embodiment of the present disclosure, the epoxy-based resin preferably has at least two epoxy groups per molecule. Particularly, the epoxy-based resin may include at least one selected from bisphenol A-type epoxy resins, bisphenol F-type epoxy resins, bisphenol S-type epoxy resins, naphthalene-type epoxy resins, anthracene epoxy resins, biphenyl-type epoxy resins, tetramethyl biphenyl-type epoxy resins, phenol novolak-type epoxy resins, cresol novolak-type epoxy resins, bisphenol A novolak-type epoxy resins, bisphenol S novolak-type epoxy resins, biphenyl novolak-type epoxy resins, naphthol novolak-type epoxy resins, naphthol phenol cocondensation novolak-type epoxy resins, naphthol cresol cocondensation novolak-type epoxy resins, aromatic hydrocarbon formaldehyde resin-modified phenolic resin-type epoxy resins, triphenyl methane-type epoxy resins, tetraphenylethane-type epoxy resins, dicyclopentadiene phenol adduct-type epoxy resins, phenol aralkyl-type epoxy resins and naphthol aralkyl-type epoxy resins, but is not limited thereto.

Among them, in terms of heat resistance, insulation reliability and adhesiveness, the epoxy-based resin more preferably includes at least one of bisphenol A-type epoxy resins, bisphenol F-type epoxy resins, naphthalene-type epoxy resins, biphenyl-type epoxy resins, or the like.

In an exemplary embodiment of the present disclosure, the first layer and the second layer include an epoxy-based resin, and thus provide an effect of reinforcing the flexibility of the insulating film and improving the brittleness.

In an exemplary embodiment of the present disclosure, the cyanate ester-based resin may include at least one selected from novolak-type (phenol novolak-type, alkylphenol novolak-type, etc.) cyanate ester-based resins, dicyclopentadiene-type cyanate ester-based resins, bisphenol-type (bisphenol A-type, bisphenol F-type, bisphenol S-type, bisphenol M-type, etc.) cyanate ester-based resins and partially triazinated prepolymers thereof, but is not limited thereto.

Particularly, the cyanate ester-based resin may include at least one selected from bifunctional cyanate resins, such as bisphenol A dicyanate, polyphenol cyanate, oligo(3-methylene-1,5-phenylene cyanate), 4,4'-methylene bis(2,6-dimethylphenyl cyanate), 4,4'-ethylidene diphenyl dicyanate, hexafluorobisphenol A dicyanate, 2,2-bis(4-cyanato)phenyl propane, 1,1-bis(4-cyanatophenylmethane), bis(4-cyanato-3,5-dimethylphenyl)methane, 1,3-bis(4-cyanatophenyl-1-(methylethylidene))benzene, bis(4-cyanatophenyl)thioether, bis(4-cyanatophenyl)ether, etc.; multifunctional cyanate resins derived from phenol novolak, cresol novolak, dicyclopentadiene structure-containing phenol resins, etc.; and partially triazinated prepolymers thereof.

The cyanate ester-based resin may have a weight average molecular weight of 500 g/mol to 4,500 g/mol, or 600 g/mol to 3,000 g/mol, but is not limited thereto.

In an exemplary embodiment of the present disclosure, the weight average molecular weight may be determined through gel permeation chromatography (GPC) (polystyrene standards).

In an exemplary embodiment of the present disclosure, the insulating film includes the cyanate ester-based resin merely in the first layer, thereby providing an effect of realizing a low dissipation factor. Particularly, when a phenolic resin is incorporated to an insulating film, a dissipation factor of 0.013 to 0.015 appears based on 10 GHz. The insulating film according to an exemplary embodiment of the present disclosure includes a cyanate ester-based resin in the first layer, and thus shows a low dissipation factor of 0.001 to 0.006 based on 10 GHz.

According to an exemplary embodiment of the present disclosure, the phenol-based resin is a compound containing a phenol backbone or naphthol backbone and may include at least one selected from biphenyl type phenol-based resins and novolak type phenol-based resins having excellent heat resistance, water resistance, or the like. Particularly, the phenol-based resin may be a novolak-type phenol-based resin. More particularly, the phenol-based resin may include at least one selected from biphenyl aralkyl-type phenolic resins, phenol novolak resins, bisphenol A novolak resins, cresol novolak resins, phenol-modified xylene resins, alkylphenol resins and phenol-modified melamine resins.

In an exemplary embodiment of the present disclosure, the insulating film includes a phenol-based resins merely in the second layer, and thus can form a suitable roughness in the roughening treatment step and provide an effect of improving plating adhesion by virtue of improved polarity.

In an exemplary embodiment of the present disclosure, the inorganic filler may include silica particles.

In an exemplary embodiment of the present disclosure, the inorganic filler include silica particles alone, and does not include any inorganic filler other than silica particles.

In an exemplary embodiment of the present disclosure, particular examples of silica may include spherical silica, molten silica, hollow silica, crystalline silica, amorphous silica, etc., but are not limited thereto.

In an exemplary embodiment of the present disclosure, the silica particles may have an average particle diameter of 0.3 µm or less, or 0.2 µm or less, and 0.05 µm or more.

In an exemplary embodiment of the present disclosure, the inorganic filler may be a commercially available filler, such as SOC1, SOC2 (Admatechs), etc.

In an exemplary embodiment of the present disclosure, as the inorganic filler, an inorganic filler surface-treated with phenylaminosilane or inorganic filler surface-treated with epoxysilane is used. Particularly, the inorganic filler surface-treated with phenylaminosilane is used in the first layer of the insulating film, and the inorganic filler surface-treated with epoxysilane is used in the second layer of the insulating film.

In general, while the resin composition of the surface layer portion is etched to a predetermined thickness through wet roughening treatment, a protrusion shape of the inorganic filler portion protrudes or a dented shape generated by elimination of the inorganic filler is formed. Herein, the type of the inorganic filler is an important factor determining the surface roughness. When using a non-surface treated inorganic filler (silica), an excessively high surface roughness appears even though the resin composition is etched well, resulting in the problem of degradation of adhesion. On the other hand, according to an exemplary embodiment of the present disclosure, each of the above-mentioned inorganic fillers is applied to each of the first layer and the second layer, thereby making it possible to form a desired surface roughness through the roughening treatment.

Particularly, when each of the first layer and the second layer includes such an inorganic filler surface-treated with a different material like the exemplary embodiment of the present disclosure, the layers show different etching rates to the roughening treatment solution to cause non-uniform etching of the surface layer portion during the roughening treatment step, thereby forming a desired surface roughness.

In an exemplary embodiment of the present disclosure, the surface-treated inorganic filler that may be used includes a product surface-treated with epoxysilane (Admatechs SC-2050-MB), product surface-treated with phenylaminosilane (Admatechs SC-2050-MTO), or the like, but is not limited thereto.

In an exemplary embodiment of the present disclosure, each of the first layer and the second layer may further include a thermoplastic resin in order to improve mechanical strength, film formability, etc. Such a thermoplastic resin may include at least one selected from phenoxy resins, polyimide resins, polyamideimide resins, polyetherimide resins, polysulfone resins, polyethersulfone resins, polyphenylene ether resins, polycarbonate resins, polyetheretherketone resins, polyester resins, polyvinyl acetal resins and polyvinylbutyral resins. More preferably, the thermoplastic resin may include a phenoxy resin.

In an exemplary embodiment of the present disclosure, each of the first layer and the second layer may further include at least one thermoplastic resin selected from phenoxy resins, polyimide resins, polyamideimide resins, polyetherimide resins, polysulfone resins, polyethersulfone resins, polyphenylene ether resins, polycarbonate resins, polyetheretherketone resins, polyester resins, polyvinyl acetal resins and polyvinylbutyral resins.

In an exemplary embodiment of the present disclosure, the thermoplastic resin may have a weight average molecular weight of 5,000 g/mol to 200,000 g/mol, but is not limited thereto.

In an exemplary embodiment of the present disclosure, the first layer and the second layer can retain a film shape in a curing step by incorporating a thermoplastic resin thereto. Particularly, when no thermoplastic resin is incorporated, there is a problem in that the layers undergo a decrease in viscosity during warming and roll down. On the contrary, an exemplary embodiment of the present disclosure includes a thermoplastic resin and retains or improves viscosity, and thus can retain a film shape even in a curing step.

In an exemplary embodiment of the present disclosure, each of the first layer and the second layer further includes an additive, which is at least one selected from a curing accelerator, a leveling agent, a wetting agent, an antistatic agent, a flame retardant, a crosslinking agent, a curing agent and a polymerization initiator.

In an exemplary embodiment of the present disclosure, the curing accelerator functions to reduce curing time, is known to those skilled in the art and may include a phosphorus-based curing accelerator, an amine-based curing accelerator, a imidazole-based curing accelerator, or the like. If necessary, one type of curing accelerator may be used alone, or two or more types of curing accelerators may be used in combination. In addition, the content of the curing accelerator may be varied suitably without departing from the scope of the present disclosure.

The phosphorus-based curing accelerator may include triphenylphosphine, etc., and the amine-based curing accelerator may include triethylamine, tributylamine, etc., with no particular limitation.

The imidazole-based curing accelerator may include at least one selected from 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-tria zine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline and 2-phenylimidazoline.

The curing accelerator may further include at least one selected from metallic compounds, amine-based compounds and organophosphine-based compounds.

The metallic compounds may include organometal complexes or organometal salts of metals, such as cobalt, copper, zinc, iron, nickel, manganese, tin, etc. The organometal complexes may include, but are not limited to: cobalt(II) acetylacetonate, cobalt(III) acetylacetonate, copper(II) acetylacetonate, zinc(II) acetylacetonate, iron(III) acetylacetonate, nickel(II) acetylacetonate and manganese(II) acetylacetonate, or the like. In addition, the organometal salts may include, but are not limited to: zinc octanoate, tin octanoate, zinc naphthenate, cobalt naphthenate, tin stearate, zinc stearate, or the like.

The amine-based compounds may include, but are not limited to: triethylamine, tributylamine, 4-dimethylaminopyridine, benzyldimethylamine, 2,4,6-tris(dimethylaminomethyl)phenol, 1,8-diazabicyclo(5.4.0)undecane, or the like.

In an exemplary embodiment of the present disclosure, the leveling agent functions to control the flowability of the curable resin composition during the subsequent use thereof to remove defects, such as craters, upon the subsequent application onto the surface, and includes known products, such as BYK 350, BYK 354, BYK 356, BYK 359, BYK 399, or the like, but is not limited thereto. Optionally, one type of leveling agent may be used alone, or two or more types of leveling agents may be used in combination. In addition, the content of the leveling agent may be varied suitably without departing from the scope of the present disclosure.

In an exemplary embodiment of the present disclosure, the wetting agent functions to assist aggregation of the inorganic filler by accelerate wetting, and includes any material known to those skilled in the art with no particular limitation. If necessary, one type of wetting agent may be used alone, or two or more types of wetting agents may be used in combination. In addition, the content of the wetting agent may be varied suitably without departing from the scope of the present disclosure.

In an exemplary embodiment of the present disclosure, the antistatic agent functions to impart an antistatic effect and includes any material known to those skilled in the art. If necessary, one type of antistatic agent may be used alone, or two or more types of antistatic agents may be used in combination. In addition, the content of the antistatic agent may be varied suitably without departing from the scope of the present disclosure.

In an exemplary embodiment of the present disclosure, the flame retardant functions to reduce flammability or to delay combustion and includes any material known to those skilled in the art with no particular limitation. If necessary, one type of flame retardant may be used alone, or two or more types of flame retardants may be used in combination. In addition, the content of the flame retardant may be varied suitably without departing from the scope of the present disclosure.

In an exemplary embodiment of the present disclosure, the crosslinking agent functions to form a crosslinking bond between polymer molecules, and includes known products, such as TAIC, DAIC (allyl-based), ALP-d (benzoxazine-based), or the like, with no particular limitation. If necessary, one type of crosslinking agent may be used alone, or two or more types of crosslinking agents may be used in combination. In addition, the content of the crosslinking agent may be varied suitably without departing from the scope of the present disclosure.

In an exemplary embodiment of the present disclosure, the curing agent is a material added to a curable resin to assist curing reaction. Such curing agents are known to those skilled in the art and may be classified into active ester-based curing agents, phenolic curing agents, cyanate ester-based curing agents, or the like, with no particular limitation. If necessary, one type of curing agent may be used alone, or two or more types of curing agents may be used in combination. In addition, the content of the curing agent may be varied suitably without departing from the scope of the present disclosure.

In an exemplary embodiment of the present disclosure, the polymerization initiator functions to initiate polymerization through the generation of radicals or (cat)ions by a specific stimulation, includes known materials, such as dicumyl peroxide, t-butylcumyl peroxide, di-t-butyl peroxide, or the like, with no particular limitation. If necessary, one type of polymerization initiator may be used alone, or two or more types of polymerization initiators may be used in combination. In addition, the content of the polymerization initiator may be varied suitably without departing from the scope of the present disclosure.

In an exemplary embodiment of the present disclosure, in the first layer, the weight ratio of inorganic filler: resin ranges from 80:20 to 40:60.

Herein, the resin mentioned in the weight ratio of the first layer is the sum of the weights of all resins contained in the first layer. For example, when the first layer includes an epoxy-based resin, a cyanate ester-based resin and a phenoxy resin, the resin is the sum of the total weights of the epoxy-based resin, the cyanate ester-based resin and the phenoxy resin.

In an exemplary embodiment of the present disclosure, in the second layer, the weight ratio of inorganic filler:resin ranges from 80:20 to 40:60.

Herein, the resin mentioned in the weight ratio of the second layer is the sum of the weights of all resins contained in the second layer. For example, when the second layer includes an epoxy-based resin, a phenol-based resin and a phenoxy resin, the resin is the sum of the total weights of the epoxy-based resin, the phenol-based resin and the phenoxy resin.

When the content of the inorganic filler is less than 40 wt% or more than 80 wt%, it is difficult to realize a desired surface shape through the roughening treatment step undesirably.

In an exemplary embodiment of the present disclosure, the first layer has a thickness of 15 µm to 25 µm. When satisfying the above-defined range, there is provided an effect of realizing suitable dielectric properties and CTE (coefficient of thermal expansion) properties.

In an exemplary embodiment of the present disclosure, the second layer has a thickness of 1 µm to 5 µm. When the second layer has a thickness of less than 1 µm, it is totally etched in the roughening treatment step, and thus it is not possible to realize a desired level of adhesion. When the second layer has a thickness of more than 5 µm, it is not possible to realize suitable dielectric properties and CTE properties.

In an exemplary embodiment of the present disclosure, the insulating film has a coefficient of thermal expansion of 25 ppm/°C or less, as determined at a temperature range of 25°C to 120°C. Particularly, the coefficient of thermal expansion is 24 ppm/°C or less, or 22 ppm/°C or less, and 0 ppm/°C or more.

The coefficient of thermal expansion is a value determined at a temperature range of 25°C to 120°C by using a thermomechanical analyzer (TMA) after the insulating film is thermally cured at 190°C for 90 minutes.

The insulating film having a coefficient of thermal expansion that falls within the above-defined range shows little difference in expansion ratio from the support subsequently, and thus causes no generation of deformation, such as peeling or cracking.

In an exemplary embodiment of the present disclosure, the insulating film shows a dissipation factor (Df) of 0.001 to 0.006, as determined at 10 GHz according to ASTM D2520. Particularly, the dissipation factor may be 0.0011 or more, 0.0012 or more, or 0.0013 or more, and 0.0058 or less, 0.0055 or less, or 0.0052 or less.

The insulating film having the above-defined range of dissipation factor can minimize loss of transmission signals subsequently.

In an exemplary embodiment of the present disclosure, the insulating film has an adhesion of larger than 0.5 kgf/cm, as determined according to ASTM D6862. Particularly, the adhesion is 0.52 kgf/cm or more, or 0.55 kgf/cm or more, and 2 kgf/cm or less, or 1.8 kgf/cm or less.

In an exemplary embodiment of the present disclosure, a first insulation film composition and a second insulation film composition are used for forming the first layer and the second layer, respectively.

In an exemplary embodiment of the present disclosure, the first insulating film composition includes an epoxy-based resin, a cyanate ester-based resin and an inorganic filler surface-treated with phenylaminosilane.

In an exemplary embodiment of the present disclosure, the second insulating film composition includes an epoxy-based resin, a phenol-based resin and an inorganic filler surface-treated with epoxysilane.

In an exemplary embodiment of the present disclosure, the first insulating film composition and the second insulating film composition further include a thermoplastic resin.

In an exemplary embodiment of the present disclosure, the first insulating film composition and the second insulating film composition further includes an additive.

In an exemplary embodiment of the present disclosure, each of the ingredients, such as the epoxy-based resin, the cyanate ester-based resin, the phenol-based resin, the inorganic filler, the thermoplastic resin and the additive, contained in the first insulating film composition and the second insulating film composition is the same as described above with reference to the insulating film.

In an exemplary embodiment of the present disclosure, the first insulating film composition and the second insulating film composition further include a solvent. Any solvent may be used with no particular limitation, as long as it is known to those skilled in the art as allowing the formation of an insulating film. Non-limiting examples of the solvent may include at least one compound selected from the group consisting of esters, ethers, ketones, aromatic hydrocarbons and sulfoxides.

The ester solvents may include ethyl acetate, n-butyl acetate, isobutyl acetate, amyl formate, isoamyl acetate, , butyl propionate, isopropyl butyrate, ethyl butyrate, butyl butyrate, methyl lactate, ethyl lactate, gamma-butyrolactone, epsilon-caprolactone, delta-valerolactone, alkyl oxyacetate (e.g. methyl oxyacetate, ethyl oxyacetate, butyl oxyacetate (such as methyl methoxyacetate, ethyl methoxyacetate, butyl methoxyacetate, methyl ethoxyacetate, ethyl ethoxyacetate, etc.)), alkyl 3-oxypropionate (e.g. methyl 3-oxypropionate, ethyl 3-oxypropionate (such as methyl 3-methoxypropionate, ethyl 3-methoxypropionate, methyl 3-ethoxypropionate, ethyl 3-ethoxypropionate, etc.)), alkyl 2-oxypropionate (e.g. methyl 2-oxypropionate, ethyl 2-oxypropionate, propyl 2-oxypropionate (such as methyl 2-methoxypropionate, ethyl 2-methoxypropionate, propyl 2-methoxypropionate, methyl 2-ethoxypropionate, ethyl 2-ethoxypropionate, etc.)), methyl 2-oxy-2-methylpropionate and ethyl 2-oxy-2-methylpropionate (e.g. methyl 2-methoxy -2-methylpropionate, ethyl 2-ethoxy-2-methylpropionate, etc.), methyl pyruvate, ethyl pyruvate, propyl pyruvate, methyl acetoacetate, ethyl acetoacetate, methyl 2-oxobutanoate, ethyl 2-oxobutanoate, or the like.

The ether solvents may include diethylene glycol dimethyl ether, tetrahydrofuran, ethyl glycol monomethyl ether, ethylene glycol monoethyl ether, methylcellosolve acetate, ethylcellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, propylene glycol monopropyl ether acetate, or the like.

The ketone solvents may include methyl ethyl ketone (MEK), cyclohexanone, cyclopentanone, 2-heptanone, 3-heptanone, N-methyl-2-pyrrolidone, or the like.

The aromatic hydrocarbon solvents may include toluene, xylene, anisole, limonene, or the like.

The sulfoxide solvents may include dimethyl sulfoxide, or the like.

An exemplary embodiment of the present disclosure provides a printed circuit board including the above-described insulating film.

In an exemplary embodiment of the present disclosure, there is provided an insulating film including a substrate film, wherein the substrate film, the first layer and the second layer are stacked successively. When satisfying the stacking order, there is provided an effect of realizing suitable dielectric properties and CTE properties.

On the contrary, when the substrate film, the second layer and the first layer are stacked successively, there is a problem of a high surface roughness and low adhesion.

In an exemplary embodiment of the present disclosure, the insulating film may be applied as an insulating layer of a printed circuit board. In addition, the insulating film may be used as an interlayer dielectric material of a multilayer printed circuit board.

In an exemplary embodiment of the present disclosure, the insulating film may be used as a build-up insulating layer for fabricating a desired circuit board. For example, the insulating film may be for use in the formation of an interlayer dielectric forming various types of package boards including a flexible printed circuit board (PCB), rigid PCB, rigid-flexible printed circuit board (RF PCB) and a build-up printed circuit board.

In an exemplary embodiment of the present disclosure, the printed circuit board may be a multilayer printed circuit board, and the number of layers contained in the multilayer printed circuit board is not limited. For example, the multilayer printed circuit board may include a structure of 2 layers to 20 layers depending on its purpose of use, application, or the like.

Hereinafter, the present disclosure will be described in detail through examples. However, the examples according to the present disclosure may be changed into several different forms, and the scope of the present disclosure is not to be interpreted as being limited to the examples described below. The examples of the present specification are provided to describe the present disclosure more fully to those having ordinary knowledge in the art.

### <Examples>

### Example 1

First, 5 parts by weight of bisphenol A-type epoxy resin (YD-128, Kukdo Chemical), 3 parts by weight of bisphenol F-type epoxy resin (KDS-8170), 2 parts by weight of naphthalene-type epoxy resin (HP-4032D, DIC), 5 parts by weight of biphenyl-type epoxy resin (YX4000UH, Mitsubishi Chemical), 20 parts by weight of cyanate ester-based resin (LMP-500S, Arxada), 10 parts by weight of phenoxy resin (YX6954BH30, Mitsubishi Chemical), 100 parts by weight of spherical silica (average particle diameter 0.5 µm, SOC2, Admatechs) surface-treated with phenylaminosilane, and 1 parts by weight of imidazole-based curing accelerator (2PHZ-PW) were mixed in methyl ethyl ketone (MEK) as a solvent to a solid content of 70% and agitated by using an agitator at 250 rpm for 3 hours to obtain Resin mixture 1.

Next, 5 parts by weight of bisphenol A-type epoxy resin (YD-128, Kukdo Chemical), 2 parts by weight of naphthalene-type epoxy resin (HP-4032D, DIC), 10 parts by weight of biphenyl-type epoxy resin (YX4000UH, Mitsubishi Chemical), 25 parts by weight of biphenylaralkyl-type phenol resin (GPH 103, Nippon Kayaku), 20 parts by weight of phenoxy resin (YX6954BH30, Mitsubishi Chemical), 100 parts by weight of spherical silica (average particle diameter 0.5 µm, SOC2, Admatechs) surface-treated with epoxysilane, and 1 parts by weight of imidazole-based curing accelerator (2PHZ-PW) were mixed in methyl ethyl ketone (MEK) as a solvent to a solid content of 60% and agitated by using an agitator at 250 rpm for 3 hours to obtain Resin mixture 2.

The resultant Resin mixture 1 was applied uniformly onto a 40 µm PET film to a thickness of 20 µm and dried at 100°C for 5 minutes to form a first layer. Then, the resultant Resin mixture 2 was applied uniformly onto the first layer to a thickness of 5 µm and dried at 100°C for 8 minutes to form a second layer. In this manner, an insulating film having a total thickness of the first layer and the second layer of 25 µm was obtained.

### Example 2

An insulating film was obtained in the same manner as Example 1, except that Resin mixture 1 and Resin mixture 2 obtained according to Example 1 were applied uniformly to a thickness of 19 µm and 6 µm, respectively.

### Comparative Example 1

Resin mixture 1 obtained according to Example 1 was applied uniformly onto a 40 µm polyethylene terephthalate (PET) film and dried at 100°C for 5 minutes to obtain an insulating film having a thickness of 25 µm.

### Comparative Example 2

Resin mixture 2 obtained according to Example 1 was applied uniformly onto a 40 µm polyethylene terephthalate (PET) film and dried at 100°C for 5 minutes to obtain an insulating film having a thickness of 25 µm.

### Comparative Example 3

An insulating film was obtained in the same manner as Example 1, except that spherical silica surface-treated with phenylaminosilane was used instead of the spherical silica surface-treated with epoxysilane in preparing Resin mixture 2 according to Example 1.

### Comparative Example 4

An insulating film was obtained in the same manner as Example 1, except that spherical silica surface-treated with epoxysilane was used instead of the spherical silica surface-treated with phenylaminosilane in preparing Resin mixture 1 according to Example 1.

### Comparative Example 5

An insulating film was obtained in the same manner as Example 1, except the following: Resin mixture 2 obtained according to Example 1 was applied uniformly onto a 40 µm polyethylene terephthalate (PET) film to a thickness of 5 µm and dried at 100°C for 5 minutes to form a first layer, and Resin mixture 1 obtained according to Example 1 was applied uniformly onto the first layer to a thickness of 20 µm and dried at 100°C for 8 minutes to form a second layer, thereby providing an insulating film having a total thickness of the first layer and the second layer of 25 µm.

### <Test Examples>

The properties of the insulating film obtained according to each of Examples and Comparative Examples was evaluated. The results are shown in the following Table 1. The methods for evaluating the properties described in Table 1 are as follows.

### Test Example 1. Determination of dielectric constant and dissipation factor

The insulating film according to each of Examples and Comparative Examples was heated at 190°C for 90 minutes so that it might be thermally cured, and the PET film as a support was removed to obtain a cured product.

The dielectric constant and dissipation factor of the cured product were determined by using E5071C system available from Agilent Co. under the conditions of a temperature of 20°C to 25°C and a humidity of 50% or less at 10 GHz. The results are shown in Table 1.

### Test Example 2. Determination of coefficient of thermal expansion (CTE)

After the insulating film was thermally cured at 190°C for 90 minutes, a thermomechanical analyzer (TMA) was used to determine the coefficient of thermal expansion in a range of 25°C to 120°C. The results are shown in Table 1.

### Test Example 3. Determination of surface roughness (Ra, nm) and adhesion

### 1) Laminate

The insulating film according to each of Examples and Comparative Examples was laminated with a copper substrate subjected to roughening treatment by using a vacuum pressurization laminator.

### 2) Curing

The insulating film laminated with the copper substrate was subjected to precuring at 100°C for 30 minutes and then at 180°C for 30 minutes to obtain an insulating layer.

### 3) Roughening treatment

The thermally cured insulating layer was treated with a swelling solution (Swelling Dip Securiganth P, Atotech) at 80°C for 5 minutes and further treated with an oxidizing solution (Concentrate Compact P, Atotech) at 75°C for 20 minutes, and then treated with a neutralizing solution (Reduction Solution Securiganth P, Atotech) at 50°C for 20 minutes.

### 4) Plating

A plating layer was formed on the insulating layer that has been subjected to roughening treatment to a thickness of 30 µm, and heat treatment was carried out at 190°C for 60 minutes.

### 5) Determination of surface roughness (Ra, nm)

The surface roughness of the insulating film subjected to roughening treatment was determined by using an optical profiler (Nanoview 3D surface profiler NV-2700, Nanosystem) (WSI mode, 20X lens) five times per sample, and the average value was taken as surface roughness (Ra). The results are shown in Table 1.

### 6) Determination of adhesion

According to ASTM D6862, the adhesion between the plating layer and the insulating layer of the plated insulating film was determined. The results are shown in Table 1.

**[Table 1]**

| | Dielectric constant | Dissipation factor | Coefficient of thermal expansion (CTE) | Surface roughness (Ra) | Adhesion |
|---|---|---|---|---|---|
| | | | (ppm/°C) | (nm) | (kgf/cm) |
| Ex. 1 | 3.2 | 0.005 | 22 | 200 | 0.7 |
| Ex. 2 | 3.1 | 0.006 | 25 | 200 | 0.6 |
| Comp. Ex. 1 | 3.0 | 0.005 | 20 | 900 | 0.5 |
| Comp. Ex. 2 | 3.2 | 0.013 | 39 | 200 | 0.5 |
| Comp. Ex. 3 | 3.2 | 0.007 | 27 | 400 | 0.2 |
| Comp. Ex. 4 | 3.2 | 0.007 | 29 | 200 | 0.5 |
| Comp. Ex. 5 | 3.2 | 0.005 | 22 | 900 | 0.4 |

As can be seen from the above results, Example 1 shows a low surface roughness and coefficient of thermal expansion, while providing a high dielectric constant and adhesion. Example 2 using an insulating film including a first layer and a second layer has a low surface roughness, but shows a higher coefficient of thermal expansion and dissipation factor as compared to Example 1, since the second layer has a thickness of larger than 5 µm.

However, in the case of Comparative Example 1 using an insulating film including a first layer alone, it shows a higher surface roughness. Also, Comparative Example 2 using an insulating film including a second layer alone shows a higher coefficient of thermal expansion.

In addition, Comparative Example 3 in which the inorganic filler forming a first layer is the same as the inorganic filler forming a second layer (the same inorganic filler surface-treated with phenylaminosilane) shows both a higher coefficient of thermal expansion and higher surface roughness, as well as a low adhesion value. In the case of Comparative Example 4 (using the same inorganic filler surface-treated with epoxysilane in a first layer and a second layer), it shows a higher coefficient of thermal expansion.

Further, Comparative Example 5 in which the opposite stacking order of a first layer and a second layer is used shows a higher surface roughness and low adhesion.

It can be seen from the above results that the insulating film according to an exemplary embodiment of the present disclosure has a suitable surface roughness and coefficient of thermal expansion, while showing a high adhesion and dielectric constant.

Therefore, it is possible to obtain a multilayer printed circuit board having excellent wiring adhesion and chemical resistance by using the insulating film according to an exemplary embodiment of the present disclosure.

## Claims

1. An insulating film comprising:
a first layer comprising an epoxy-based resin, a cyanate ester-based resin and an inorganic filler surface-treated with phenylaminosilane; and
a second layer comprising an epoxy-based resin, a phenol-based resin and an inorganic filler surface-treated with epoxysilane.

2. The insulating film according to claim 1, wherein the first layer has a thickness of 15 µm to 25 µm.

3. The insulating film according to claim 1, wherein the second layer has a thickness of 1 µm to 5 µm.

4. The insulating film according to claim 1, wherein the cyanate ester-based resin comprises at least one selected from novolak-type cyanate ester-based resins, dicyclopentadiene-type cyanate ester-based resins, bisphenol-type cyanate ester-based resins and partially triazinated prepolymers thereof.

5. The insulating film according to claim 1, wherein the phenol-based resin comprises at least one selected from biphenyl-type phenol-based resins and novolak-type phenol-based resins.

6. The insulating film according to claim 1, wherein each of the first layer and the second layer further comprises at least one thermoplastic resin selected from phenoxy resins, polyimide resins, polyamideimide resins, polyetherimide resins, polysulfone resins, polyethersulfone resins, polyphenylene ether resins, polycarbonate resins, polyetheretherketone resins, polyester resins, polyvinyl acetal resins and polyvinylbutyral resins.

7. The insulating film according to claim 1, wherein each of the first layer and the second layer further comprises an additive, and
the additive is at least one selected from a curing accelerator, a leveling agent, a wetting agent, an antistatic agent, a flame retardant, a crosslinking agent, a curing agent and a polymerization initiator.

8. The insulating film according to claim 1, which comprises a substrate film, wherein the substrate film, the first layer and the second layer are stacked successively.

9. The insulating film according to claim 1, which has a coefficient of thermal expansion of 25 ppm/°C or less as determined at a temperature range of 25°C to 120°C.

10. The insulating film according to claim 1, which shows a dissipation factor of 0.001 to 0.006, as determined at 10 GHz according to ASTM D2520.

11. The insulating film according to claim 1, which has an adhesion of larger than 0.5 kgf/cm, as determined according to ASTM D6862.

12. A printed circuit board comprising the insulating film as defined in any one of claims 1 to 11.
